# EUROPEAN PATENT APPLICATION

(11) **EP 4 506 755 A1**
(43) Date of publication of application: **12.02.2025**
(21) Application number: 23784864.3
(22) Date of filing: 27.02.2023
(51) Int. Cl.: G03F 7/11, C08L 65/00, C08G 61/12, H01L 21/308

(54) **SPIN-ON CARBON HARD MASK COMPOSITION WITH HIGH PLANARIZATION PERFORMANCE AND PATTERNING METHOD USING SAME**

(30) Priority: 06.04.2022 KR 20220042969
(71) Applicant: Ycchem Co., Ltd., Gyeongsangbuk-do 40046 (KR)
(72) Inventor: LEE, Su Jin, Daegu 42634 (KR); KIM, Gi Hong, Dalseong-gun Daegu 42922 (KR); LEE, Jeong Hun, Daegu 42233 (KR); LEE, Seung Hun, Dalseong-gun Daegu 42918 (KR); LEE, Seung Hyun, Daegu 42747 (KR)
(74) Representative: Ter Meer Steinmeister & Partner
(86) International application number: PCT/KR2023/002689
(87) International publication number: WO 2023/195636

(57) **Abstract**

The present invention relates to a spin-on carbon hard mask composition with higher planarization performance, which is useful in semiconductor lithography processes, and a patterning method using same. The composition according to the present invention contains the 3',6'-Dihydroxy-3H-spiro[2-benzofuran-1,9'-xanthen]-3-one derivative polymer represented by the following chemical formula 1, an organic solvent, and a surfactant and exhibits excellent effects including excellent solubility, uniform coating performance, high etch-resistance enduring multi-etch processes, excellent mechanical properties, and high planarization properties.

## Description

### Technical Field

The present disclosure relates to a hardmask composition maintaining high planarization properties useful in semiconductor lithography processes, the hardmask composition being a spin-on carbon hardmask composition with high planarization performance characterized by containing a 3',6'-dihydroxy-3H-spiro[2-benzofuran-1,9'-xanthene]3-one polymer, an organic solvent, and a surfactant and by exhibiting a planarity of 20% or less at a thickness of 4,010 Å or smaller, and to a patterning method using the same.

### Background Art

With devices becoming smaller and more densely integrated, there is a demand for implementing finer patterns in semiconductor processes. Research and development are in progress on methods involving developing exposure equipment or introducing additional processes to achieve finer photoresist patterns as methods of forming such finer patterns.

Additionally, high-resolution photoresists and photolithographic process tools are being developed to increase the integration density of semiconductor devices and realize the formation of structures with fine dimensions within the nanometer range.

In semiconductor manufacturing processes, patterns were formed on a semiconductor substrate using an i-line light source with a wavelength of 365 nm in the past. However, light sources in a shorter wavelength range have been required to form finer patterns.

Recent technology trends include the development of lithography technologies using KrF (248 nm), ArF (198 nm), and extreme ultraviolet (EUV, 13.5 nm) light sources being in progress, which are either currently available or in the process of being commercialized.

Current technologies require finer patterns, so the thickness of photoresists has become gradually thinner to implement such finer patterns, ultimately resulting in photoresist pattern collapse. A layer to be etched was unable to be etched using such thinned photoresist patterns, so a layer with excellent etch resistance, called a hardmask, was introduced between a photoresist layer and the layer to be etched to better this situation. A hardmask process uses a photoresist pattern and refers to a process of etching and patterning a hardmask and then etching a layer to be etched using the hardmask pattern. The hardmask layer is manufactured using chemical vapor deposition (CVD) or spin-on coating.

There are disadvantages in hardmask layers manufactured by CVD, such as increased initial costs and process time due to the use of deposition devices and issues related to particles. To better such disadvantages, spin-on coating has developed.

Spin-on coating is a technique using spin-coatable materials to reduce costs and process time, and there are advantages, such as uniform coating properties, easy control of coating thickness, reduced process time, and reduced initial investment costs compared to CVD.

Furthermore, in the case of spin-on hardmasks, semiconductor processes have recently required technology and development related to miniaturization and pattern stacking, and there is a need to develop new hardmask layers for techniques and materials enabling wafers with the presence of finer patterns to be more evenly coated with hardmask layers.

### [Document of related art]

### [Patent Document]

(Patent Document 1) Patent Document 1: Korean Patent No. 10-0874655
(Patent Document 2) Patent Document 2: Korean Patent No. 10-1230529
(Patent Document 3) Patent Document 3: Korean Patent No. 10-1721979
(Patent Document 4) Patent Document 4: Korean Patent No. 10-1777687
(Patent Document 5) Patent Document 5: Korean Patent No. 10-2240213

### Disclosure

### Technical Problem

The present disclosure, which relates to a patterning method and a composition using a spin-on carbon hardmask during a semiconductor manufacturing process, aims to provide a spin-on carbon hardmask composition exhibiting a low refractive index, a low extinction coefficient, excellent etch resistance to dry etching, good coating performance due to even coating, and high planarization performance, and a patterning method using the hardmask composition.

### Technical Solution

The present disclosure relates to a spin-on hardmask composition with high planarization properties, the spin-on hardmask composition being characterized by: having a 3',6'-dihydroxy-3H-spiro[2-benzofuran-1,9'-xanthene]-3-one derivative polymer represented by Formula 1 shown below or a structure containing the same, the derivative polymer having a weight average molecular weight in the range of 1,000 to 5,000; and exhibiting a planarity of 20% or less at a thickness of 4,010 Å or smaller.

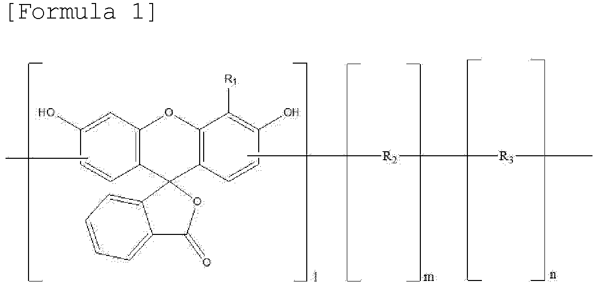

In Formula 1 shown above, l, m, and n are in ranges of 1 ≤ l ≤ 20, 1 ≤ m ≤ 40, and 1 ≤ n ≤ 20, respectively, R₁ includes any one among hydrogen (H), a hydroxy group (OH), a ketone group (CO), an ether group (COC), an aldehyde group (CHO), 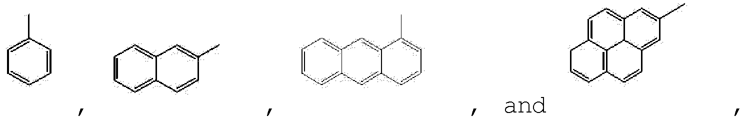 R₂ includes any one among 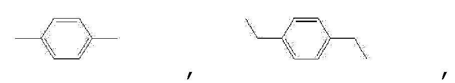 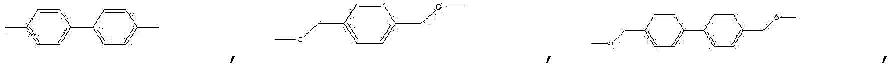 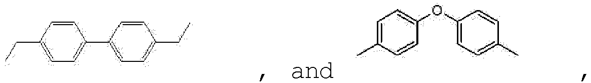 and R₃ includes any one among hydrogen (H), a hydroxy group (OH),

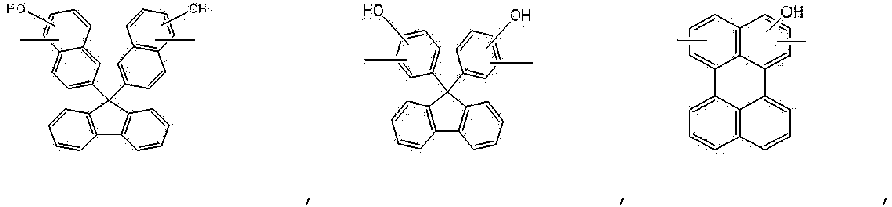

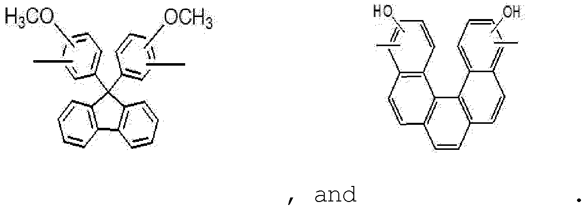

In Formula 1 shown above, the ratios of R₁, R₂, and R₃ form polymers with different proportions primarily to improve the thermal curing reactivity, etch selectivity, and planarization performance of the overall polymer structure.

In Formula 1 shown above, R₁ is a 3',6'-dihydroxy-3H-spiro[2-benzofuran-1,9'-xanthen]-3-one derivative and can improve high planarization performance.

In Formula 1 shown above, R₂ is formed primarily under a condition in the presence of an acid catalyst, and such a formed polymer compound can improve high planarization performance and is soluble in an organic solvent.

In Formula 1 shown above, R₃ primarily can enhance the etch resistance and thermal curing reactivity of the overall polymer structure.

When the weight average molecular weight of the polymer represented by Formula 1 shown above is less than 1,000, an insufficient amount of the polymer structure is generated, resulting in poor etch resistance. When the weight average molecular weight of the polymer represented by Formula 1 is greater than 5,000, the physical properties of the coated surface may be non-uniform.

The hardmask composition may include: 1 wt% to 50 wt% of the polymer represented by Formula 1 shown above; 50 wt% to 98 wt% of an organic solvent; and greater than 0 wt% to 2 wt% of a surfactant.

When the amount of the polymer component is less than 1 wt% or greater than 50 wt%, the coating thickness may be smaller or greater than the desired coating thickness, making it challenging to achieve an accurate coating thickness. Additionally, when the desired or greater coating thickness is required, coating properties may deteriorate.

The organic solvent may be one or a mixture of two or more selected from the group consisting of propyleneglycolmonomethylether (PGME), propyleneglycolmonomethylether acetate (PGMEA), cyclohexanone (CHN), cyclopentanone (CPN), γ-butyrolactone (GBL), ethyllactate (EL), methylethylketone (MEK), n-butylacetate, **N-**methylpyrrolidone (NMP), methyl 3-methoxypropionate (MMP), and ethyl 3-ethoxypropionate (EEP).

The surfactant may be one or a mixture of two or more selected from the group consisting of ionic and nonionic surfactants such as polyacrylates, polyfluorocarbons, polysiloxanes, polyoxyethylenealkylethers, polyoxyethylenealkylphenylethers, polyoxyethylenenonylphenylethers, polyoxyethyleneoctylphenylethers, polyoxyethylenepolyoxypropylenes, polyoxyethylenelaurylethers, or polyoxyethylenesorbitans.

According to another embodiment of the present disclosure, provided is a patterning method including: performing a coating process of an upper portion of a layer to be etched with the hardmask composition through spin coating; and performing a baking process to form a hardmask layer.

The spin coating thickness of the hardmask composition is not particularly limited. However, the coating thickness may be in the range of 100 Å to 20,000 Å.

The baking process may be performed at a temperature in the range of 150°C to 400°C for 1 to 5 minutes, thus causing a self-crosslinking reaction.

### Advantageous Effects

A spin-on carbon hardmask composition with high planarization performance and a patterning method using the hardmask composition, according to the present disclosure, provides a planarized coating layer showing good coating performance and exhibiting a planarity of 20% or less at a thickness of 4,010 Å or smaller, thus realizing high planarization performance. Additionally, the hardmask composition exhibits a low refractive index, a low extinction coefficient, high etch selectivity, and sufficient multi-etch resistance, and thus can provide excellent performance when forming fine patterns of semiconductors.

### Description of Drawings

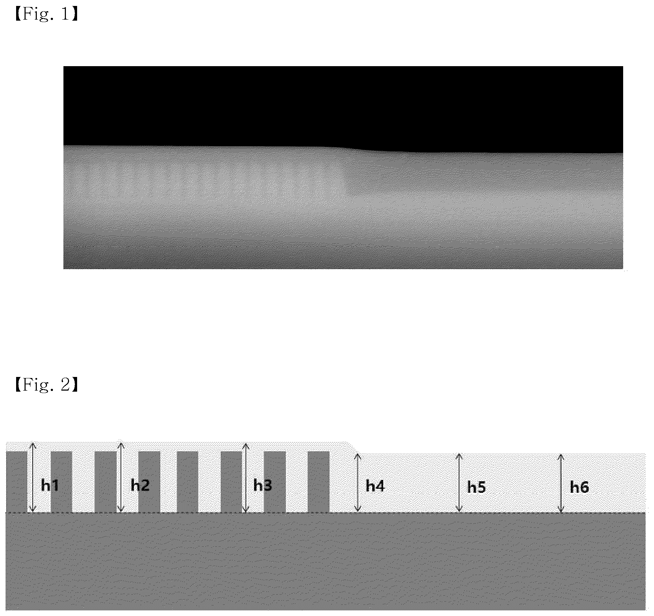

FIG. 1 shows field-emission scanning electron microscopy (FE-SEM) data related to planarization properties of a polymer provided by Experimental Example 5; and
FIG. 2 is a diagram related to equations for calculating planarity from planarization properties.

### Best Mode

Hereinbelow, a carbon hardmask composition, according to the present disclosure, will be described in detail.

The present disclosure provides a spin-on hardmask composition with high planarization properties, the spin-on hardmask composition being characterized by: having a 3',6'-dihydroxy-3H-spiro[2-benzofuran-1,9'-xanthene]-3-one derivative polymer represented by Formula 1 shown below or a structure containing the same, the derivative polymer having a weight average molecular weight in the range of 1,000 to 5,000, preferably in the range of 1,000 to 4,000, and more preferably in the range of 1,500 to 3,000; and exhibiting planarity of 20% or less at a thickness of 4,010 Å or smaller.

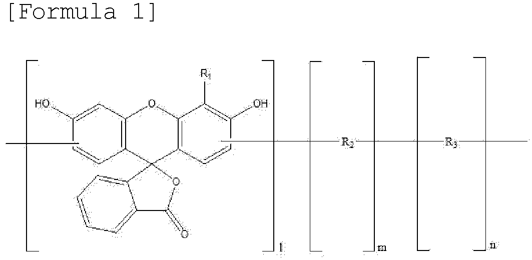

In Formula 1 shown above, l, m, and n are in ranges of 1 ≤ l ≤ 20, 1 ≤ m ≤ 40, and 1 ≤ n ≤ 20, respectively, R₁ includes any one among hydrogen (H), a hydroxy group (OH), a ketone group (CO), an ether group (COC), an aldehyde group (CHO), 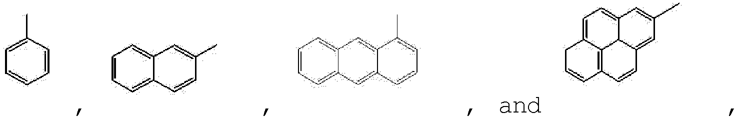 R₂ includes any one among 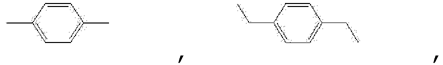 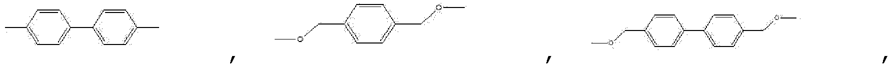 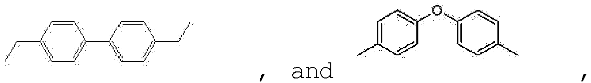 and R₃ includes any one among hydrogen (H), a hydroxy group (OH),

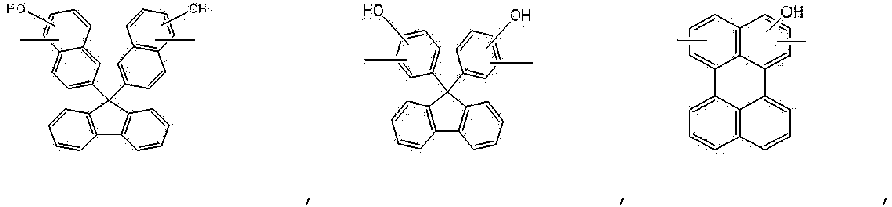

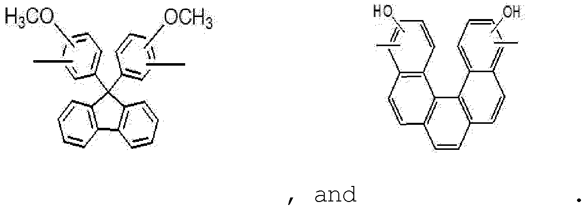

In Formula 1 shown above, the ratios of R₁, R₂, and R₃ form polymers with different proportions primarily to improve the thermal curing reactivity, etch selectivity, and planarization performance of the overall polymer structure.

In Formula 1 shown above, R₁ is a 3',6'-dihydroxy-3H-spiro[2-benzofuran-1,9'-xanthen]-3-one derivative and can improve high planarization performance.

In Formula 1 shown above, R₂ is formed primarily under a condition in the presence of an acid catalyst, and such a formed polymer compound can improve high planarization performance and is soluble in an organic solvent.

In Formula 1 shown above, R₃ primarily can enhance the etch resistance and thermal curing reactivity of the overall polymer structure.

When the weight average molecular weight of the polymer represented by Formula 1 shown above is less than 1,000, an insufficient amount of the polymer structure is generated, resulting in poor etch resistance. When the weight average molecular weight of the polymer represented by Formula 1 is greater than 5,000, the physical properties of the coated surface may be non-uniform.

The hardmask composition may include: 1 wt% to 50 wt% of the polymer represented by Formula 1 shown above; 50 wt% to 98 wt% of an organic solvent; and greater than 0 wt% to 2 wt% of a surfactant.

When the amount of the polymer component is less than 1 wt% or greater than 50 wt%, the coating thickness may be smaller or greater than the desired coating thickness, making it challenging to achieve an accurate coating thickness. Additionally, when the desired or greater coating thickness is required, coating properties may deteriorate.

The organic solvent may be one or a mixture of two or more selected from the group consisting of propyleneglycolmonomethylether (PGME), propyleneglycolmonomethylether acetate (PGMEA), cyclohexanone (CHN), cyclopentanone (CPN), γ-butyrolactone (GBL), ethyllactate (EL), methylethylketone (MEK), n-butylacetate, **N-**methylpyrrolidone (NMP), methyl 3-methoxypropionate (MMP), and ethyl 3-ethoxypropionate (EEP).

The surfactant may be one or a mixture of two or more selected from the group consisting of ionic and nonionic surfactants such as polyacrylates, polyfluorocarbons, polysiloxanes, polyoxyethylenealkylethers, polyoxyethylenealkylphenylethers, polyoxyethylenenonylphenylethers, polyoxyethyleneoctylphenylethers, polyoxyethylenepolyoxypropylenes, polyoxyethylenelaurylethers, or polyoxyethylenesorbitans.

According to another embodiment of the present disclosure, provided is a patterning method including: performing a coating process of an upper portion of a layer to be etched with the hardmask composition through spin coating; and performing a baking process to form a hardmask layer.

The spin coating thickness of the hardmask composition is not particularly limited. However, the coating thickness may be in the range of 100 Å to 20,000 Å.

The baking process may be performed at a temperature in the range of 150°C to 400°C for 1 to 5 minutes, thus causing a self-crosslinking reaction.

Hereinbelow, preferred embodiments and comparative examples of the present disclosure will be described. However, the following examples are only preferred examples of the present disclosure, and the present disclosure is not limited to the examples shown below.

### Mode for Invention

### Example 1

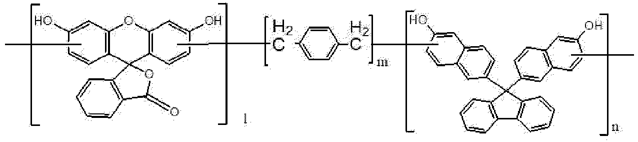

A nitrogen atmosphere was created after placing 15.0 g (0.045 mol) of 3',6'-dihydroxy-3H-spiro[2-benzofuran-1,9'-xanthen]-3-one, 15.0 g (0.090 mol) of 1,4-bismethoxymethylbenzene, 20.3 g (0.045 mol) of 9,9-bis(6-hydroxy-2-naphthyl)fluorene, and 150 g of propyleneglycolmonomethyletheracetate in a four-necked flask. Then, 0.07 g (0.00045 mol) of diethylsulfate, an initiator, was added to the reactor, followed by heating the solution to 140°C for 9 hours while being refluxed. After completion of the reaction, the resulting solution was purified with a solution of ethanol and water (9:1), recrystallized using a solution of ethanol and distilled water (9:1), and then dried in vacuo. As a result of GPC measurement, a polymer compound having a weight average molecular weight (Mw) by standard polystyrene conversion of 1,500 was obtained.

### Example 2

A polymer compound was synthesized through the same process as in Example 1, except for conducting the reaction for 15 hours. As a result of GPC measurement, the weight average molecular weight (Mw) by standard polystyrene conversion of the obtained polymer compound was 3,000.

### Example 3

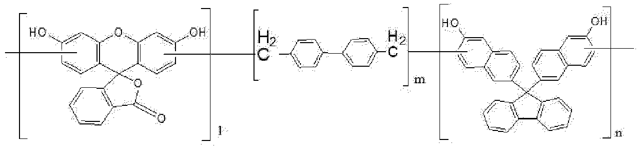

A nitrogen atmosphere was created after placing 15.0 g (0.045 mol) of 3',6'-dihydroxy-3H-spiro[2-benzofuran-1,9'-xanthen]-3-one, 21.7 g (0.090 mol) of 4,4'-bis(methoxymethyl)-1,1'-biphenyl, 20.3 g (0.045 mol) of 9,9-bis(6-hydroxy-2-naphthyl)fluorene, and 150 g of propyleneglycolmonomethyletheracetate in a four-necked flask. Then, 0.07 g (0.00045 mol) of diethylsulfate, an initiator, was added to the reactor, followed by heating the solution to 140°C for 9 hours while being refluxed. After completion of the reaction, the resulting solution was purified with a solution of ethanol and water (9:1), recrystallized using a solution of ethanol and distilled water (9:1), and then dried in vacuo. As a result of GPC measurement, a polymer compound having a weight average molecular weight (Mw) by standard polystyrene conversion of 1,500 was obtained.

### Example 4

A polymer compound was synthesized through the same process as in Example 3, except for conducting the reaction for 15 hours. As a result of GPC measurement, the weight average molecular weight (Mw) by standard polystyrene conversion of the obtained polymer compound was 3,000.

### Example 5

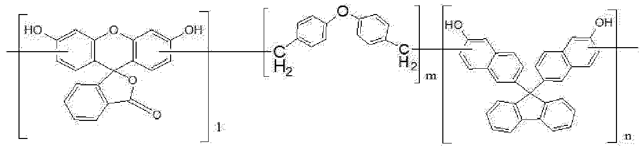

A nitrogen atmosphere was created after placing 15.0 g (0.045 mol) of 3',6'-dihydroxy-3H-spiro[2-benzofuran-1,9'-xanthen]-3-one, 23.1 g (0.090 mol) of 4,4'-bis(methoxymethyl)diphenyl ether, 20.3 g (0.045 mol) of 9,9-bis(6-hydroxy-2-naphthyl)fluorene, and 150 g of propyleneglycolmonomethyletheracetate in a four-necked flask. Then, 0.07 g (0.00045 mol) of diethylsulfate, an initiator, was added to the reactor, followed by heating the solution to 140°C for 9 hours while being refluxed. After completion of the reaction, the resulting solution was purified with a solution of ethanol and water (9:1), recrystallized using a solution of ethanol and distilled water (9:1), and then dried in vacuo. As a result of GPC measurement, a polymer compound having a weight average molecular weight (Mw) by standard polystyrene conversion of 1,500 was obtained.

### Example 6

A polymer compound was synthesized through the same process as in Example 5, except for conducting the reaction for 15 hours. As a result of GPC measurement, the weight average molecular weight (Mw) by standard polystyrene conversion of the obtained polymer compound was 3,000.

### Example 7

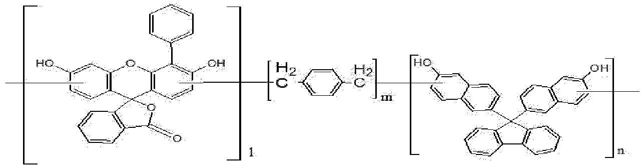

A nitrogen atmosphere was created after placing 18.3 g (0.045 mol) of 3',6'-dihydroxy-3H-spiro[2-benzofuran(5-phenyl)-1,9'-xanthen]-3-one, 15.0 g (0.090 mol) of 1,4-bismethoxymethylbenzene, 20.3 g (0.045 mol) of 9,9-bis(6-hydroxy-2-naphthyl)fluorene, and 150 g of propyleneglycolmonomethyletheracetate in a four-necked flask. Then, 0.07 g (0.00045 mol) of diethylsulfate, an initiator, was added to the reactor, followed by heating the solution to 140°C for 9 hours while being refluxed. After completion of the reaction, the resulting solution was purified with a solution of ethanol and water (9:1), recrystallized using a solution of ethanol and water (9:1), and then dried in vacuo. As a result of GPC measurement, a polymer compound having a weight average molecular weight (Mw) by standard polystyrene conversion of 1,500 was obtained.

### Example 8

A polymer compound was synthesized through the same process as in Example 7, except for conducting the reaction for 15 hours. As a result of GPC measurement, the weight average molecular weight (Mw) by standard polystyrene conversion of the obtained polymer compound was 3,000.

### Example 9

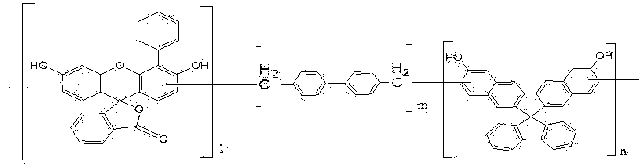

A nitrogen atmosphere was created after placing 18.3 g (0.045 mol) of 3',6'-dihydroxy-3H-spiro[2-benzofuran(5-phenyl)-1,9'-xanthen]-3-one, 21.7 g (0.090 mol) of 4,4'-bis(methoxymethyl)-1,1'-biphenyl, 20.3 g (0.045 mol) of 9,9-bis(6-hydroxy-2-naphthyl)fluorene, and 150 g of propyleneglycolmonomethyletheracetate in a four-necked flask. Then, 0.07 g (0.00045 mol) of diethylsulfate, an initiator, was added to the reactor, followed by heating the solution to 140°C for 9 hours while being refluxed. After completion of the reaction, the resulting solution was purified with a solution of ethanol and water (9:1), recrystallized using a solution of ethanol and water (9:1), and then dried in vacuo. As a result of GPC measurement, a polymer compound having a weight average molecular weight (Mw) by standard polystyrene conversion of 1,500 was obtained.

### Example 10

A polymer compound was synthesized through the same process as in Example 9, except for conducting the reaction for 15 hours. As a result of GPC measurement, the weight average molecular weight (Mw) by standard polystyrene conversion of the obtained polymer compound was 3,000.

### Example 11

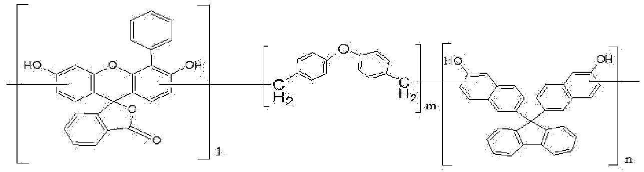

A nitrogen atmosphere was created after placing 18.3 g (0.045 mol) of 3',6'-dihydroxy-3H-spiro[2-benzofuran(5-phenyl)-1,9'-xanthen]-3-one, 23.1 g (0.090 mol) of 4,4'-bis(methoxymethyl)diphenyl ether, 20.3 g (0.045 mol) of 9,9-bis(6-hydroxy-2-naphthyl)fluorene, and 150 g of propyleneglycolmonomethyletheracetate in a four-necked flask. Then, 0.07 g (0.00045 mol) of diethylsulfate, an initiator, was added to the reactor, followed by heating the solution to 140°C for 9 hours while being refluxed. After completion of the reaction, the resulting solution was purified with a solution of ethanol and water (9:1), recrystallized using a solution of ethanol and water (9:1), and then dried in vacuo. As a result of GPC measurement, a polymer compound having a weight average molecular weight (Mw) by standard polystyrene conversion of 1,500 was obtained.

### Example 12

A polymer compound was synthesized through the same process as in Example 11, except for conducting the reaction for 15 hours. As a result of GPC measurement, the weight average molecular weight (Mw) by standard polystyrene conversion of the obtained polymer compound was 3,000.

*

### Comparative Example 1

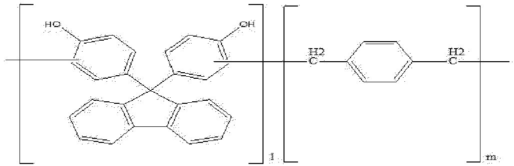

A nitrogen atmosphere was created after placing 20 g (1 mol) of 9,9-bis(4-hydroxyphenyl)fluorene, 9.5 g (1 mol) of 1,4-bismethoxymethylbenzene, and 150 g of propyleneglycolmonomethyletheracetate in a four-necked flask. Then, 0.07 g (0.01 mol) of diethylsulfate, an initiator, was added to the reactor, followed by heating the solution to 140°C for 10 hours while being refluxed. The resulting solution was purified in the same manner as in Example 1, thereby obtaining a compound having a weight average molecular weight (Mw) by standard polystyrene conversion of 1,500.

### Comparative Example 2

A compound was synthesized and purified through the same process as in Comparative Example 1, except for conducting the reaction for 14 hours. As a result of GPC measurement, the weight average molecular weight (Mw) by standard polystyrene conversion of the obtained polymer compound was 4,000.

### Comparative Example 3

A compound was synthesized and purified through the same process as in Comparative Example 1, except for conducting the reaction for 16 hours. As a result of GPC measurement, the weight average molecular weight (Mw) by standard polystyrene conversion of the obtained polymer compound was 5,000.

### Experimental Example 1

About 3.0 g of the polymer compound obtained in Example 1, 13.6 g of propyleneglycolmonomethyletheracetate, and 3.4 g of cyclohexanone were placed and stirred for 24 hours for dissolution. The dissolved solution was filtered through a 0.2 µm fine filter, followed by preparing a composition for forming a hardmask film. An upper surface of a silicon wafer was coated with the prepared solution using spin coater equipment. The wafer coated with the solution was placed on a hot plate, heated to 240°C for 1 minute, and continuously heated to 400°C for 1 minute to form a hardmask film.

### Experimental Example 2

A hardmask film was formed in the same manner as in Experimental Example 1, except for using 3.0 g of the polymer compound obtained in Example 2.

### Experimental Example 3

A hardmask film was formed in the same manner as in Experimental Example 1, except for using 3.0 g of the polymer compound obtained in Example 3.

### Experimental Example 4

A hardmask film was formed in the same manner as in Experimental Example 1, except for using 3.0 g of the polymer compound obtained in Example 4.

### Experimental Example 5

A hardmask film was formed in the same manner as in Experimental Example 1, except for using 3.0 g of the polymer compound obtained in Example 5.

### Experimental Example 6

A hardmask film was formed in the same manner as in Experimental Example 1, except for using 3.0 g of the polymer compound obtained in Example 6.

### Experimental Example 7

A hardmask film was formed in the same manner as in Experimental Example 1, except for using 3.0 g of the polymer compound obtained in Example 7.

### Experimental Example 8

A hardmask film was formed in the same manner as in Experimental Example 1, except for using 3.0 g of the polymer compound obtained in Example 8.

### Experimental Example 9

A hardmask film was formed in the same manner as in Experimental Example 1, except for using 3.0 g of the polymer compound obtained in Example 9.

### Experimental Example 10

A hardmask film was formed in the same manner as in Experimental Example 1, except for using 3.0 g of the polymer compound obtained in Example 10.

### Experimental Example 11

A hardmask film was formed in the same manner as in Experimental Example 1, except for using 3.0 g of the polymer compound obtained in Example 11.

### Experimental Example 12

A hardmask film was formed in the same manner as in Experimental Example 1, except for using 3.0 g of the polymer compound obtained in Example 12.

### Comparative Experimental Example 1

A hardmask film was formed in the same manner as in Experimental Example 1, except for using 3.0 g of the polymer compound obtained in Comparative Example 1.

### Comparative Experimental Example 2

A hardmask film was formed in the same manner as in Experimental Example 1, except for using 3.0 g of the polymer compound obtained in Comparative Example 2.

### Comparative Experimental Example 3

A hardmask film was formed in the same manner as in Experimental Example 1, except for using 3.0 g of the polymer compound obtained in Comparative Example 3.

### <Evaluation of gap-filling properties>

*Using a spin coater, a patterned wafer was coated with each solution prepared in Experimental Examples 1 to 12 and Comparative Experimental Examples 1 to 3. The presence or absence of voids was determined by measuring the cross section of the wafer. The experiment was repeatedly conducted five times using each sample, and a scanning electron microscope (FE-SEM, Hitachi) was used as measuring equipment to examine the cross sections. The measurement results thereof are shown in Table 1.

**[Table 1]**

| | Sample | Presence or absence of voids (O in presence of voids) |
|---|---|---|
| Experimental Example 1 | Example 1 | X |
| Experimental Example 2 | Example 2 | O |
| Experimental Example 3 | Example 3 | X |
| Experimental Example 4 | Example 4 | X |
| Experimental Example 5 | Example 5 | X |
| Experimental Example 6 | Example 6 | X |
| Experimental Example 7 | Example 7 | X |
| Experimental Example 8 | Example 8 | O |
| Experimental Example 9 | Example 9 | X |
| Experimental Example 10 | Example 10 | X |
| Experimental Example 11 | Example 11 | X |
| Experimental Example 12 | Example 12 | X |
| Comparative Experimental Example 1 | Comparative Example 1 | X |
| Comparative Experimental Example 2 | Comparative Example 2 | O |
| Comparative Experimental Example 3 | Comparative Example 3 | O |

The evaluation results of the gap-filling properties of the hardmask films are shown in Table 1. These results confirmed that voids were present in the case of Experimental Examples 2 and 8 and Comparative Experimental Examples 2 and 3.

### <Evaluation of planarization properties>

Using a spin coater, a patterned wafer was coated with each solution prepared in Experimental Examples 1 to 12 and Comparative Experimental Examples 1 to 3. The cross section of the wafer was measured, and the step height at the pattern boundary area was examined. The experiment was repeatedly conducted five times using each sample. The planarization performance was quantified using Equation 1 shown below. A scanning electron microscope (FE-SEM, Hitachi) was used as measuring equipment to examine the cross sections. The measurement results thereof are shown in Table 2. Planarity (%) = [{(h1 + h2 + h3)/3 - (h4 + h5 + h6)/3}/{ (h1 + h2 + h3)/3}] x 100

**[Table 2]**

| | Sample | Planarity (%) |
|---|---|---|
| Experimental Example 1 | Example 1 | 10.5 |
| Experimental Example 2 | Example 2 | - |
| Experimental Example 3 | Example 3 | 9.3 |
| Experimental Example 4 | Example 4 | 17.2 |
| Experimental Example 5 | Example 5 | 9.2 |
| Experimental Example 6 | Example 6 | 17.0 |
| Experimental Example 7 | Example 7 | 9.7 |
| Experimental Example 8 | Example 8 | - |
| Experimental Example 9 | Example 9 | 9.6 |
| Experimental Example 10 | Example 10 | 15.9 |
| Experimental Example 11 | Example 11 | 9.6 |
| Experimental Example 12 | Example 12 | 15.8 |
| Comparative Experimental Example 1 | Comparative Example 1 | 47.2 |
| Comparative Experimental Example 2 | Comparative Example 2 | - |
| Comparative Experimental Example 3 | Comparative Example 3 | - |

The evaluation results of the planarization properties of the hardmask films are shown in Table 2 above. According to the evaluation results, it was confirmed that better planarization performance was exhibited in the case of Experimental Examples 1, 3 to 7, and 9 to 12 than in the case of Comparative Experimental Example 1. In comparison, voids were present in the case of Experimental Examples 2 and 8 and Comparative Experimental Examples 2 and 3, so the planarization properties were not evaluated in these cases. The planarity of the hardmask film may be defined as excellent when the planarity compared to the coating thickness is 20% or less. Experimental Examples 1, 3 to 7, and 9 to 12 exhibited excellent planarization performance, and Experimental Example 5 was evaluated as the best with a 9.2% planarity.

### <Test of coating thickness properties>

The thickness of each hardmask film formed in Experimental Examples 1 to 12 and Comparative Experimental Examples 1 to 3 were measured. The results thereof are shown in Table 3. An ellipsometer (Horiba) was used.

**[Table 3]**

| | Sample | Coating thickness (Å) | Coating properties |
|---|---|---|---|
| Experimental Example 1 | Example 1 | 4010 | Good |
| Experimental Example 2 | Example 2 | 4002 | Good |
| Experimental Example 3 | Example 3 | 4005 | Good |
| Experimental Example 4 | Example 4 | 4008 | Good |
| Experimental Example 5 | Example 5 | 4005 | Good |
| Experimental Example 6 | Example 6 | 4003 | Good |
| Experimental Example 7 | Example 7 | 4002 | Good |
| Experimental Example 8 | Example 8 | 4001 | Good |
| Experimental Example 9 | Example 9 | 4007 | Good |
| Experimental Example 10 | Example 10 | 4005 | Good |
| Experimental Example 11 | Example 11 | 4006 | Good |
| Experimental Example 12 | Example 12 | 4004 | Good |
| Comparative Experimental Example 1 | Comparative Example 1 | 4001 | Good |
| Comparative Experimental Example 2 | Comparative Example 2 | 4005 | Good |
| Comparative Experimental Example 3 | Comparative Example 3 | 3650 | Poor |

As a result of coating using the compounds of the experimental examples and comparative experimental examples, Comparative Experimental Example 3 was evaluated as poor in terms of coating properties because the surface of the wafer failed to be evenly coated, and the physical properties of the coated surface were non-uniform.

### <Measurement of weight average molecular weight>

The weight average molecular weight of the samples obtained in the above examples was analyzed using gel permeation chromatography (GPC). A product purchased from Shodex was used as a column during the analysis, and the measurement conditions were as follows.

Column temperature: 40°C, Mobile phase: tetrahydrofuran (THF), Flow rate: 1 mL/1 min, GPC column used: KF-801, 802, 803 (purchased from Shodex, 8 X 300 mm). The results thereof are shown in Table 4.

**[Table 4]**

| | Number average molecular weight | Weight average molecular weight | Weight average molecular weight/Number average molecular weight |
|---|---|---|---|
| Experimental Example 1 | 1,001 | 1,510 | 1.51 |
| Experimental Example 2 | 1,412 | 2,980 | 2.11 |
| Experimental Example 3 | 934 | 1,523 | 1.63 |
| Experimental Example 4 | 1,398 | 2,991 | 2.14 |
| Experimental Example 5 | 923 | 1,513 | 1.64 |
| Experimental Example 6 | 1,401 | 2,981 | 2.13 |
| Experimental Example 7 | 943 | 1,517 | 1.61 |
| Experimental Example 8 | 1,414 | 2,983 | 2.11 |
| Experimental Example 9 | 920 | 1,509 | 1.64 |
| Experimental Example 10 | 1,405 | 2,992 | 2.13 |
| Experimental Example 11 | 916 | 1,511 | 1.65 |
| Experimental Example 12 | 1,393 | 2,995 | 2.15 |
| Comparative Experimental Example 1 | 656 | 1,502 | 2.29 |
| Comparative Experimental Example 2 | 1,656 | 4,024 | 2.43 |
| Comparative Experimental Example 3 | 1,938 | 5,022 | 2.59 |

### <Test of optical properties>

The refractive index n and extinction coefficient k of each hardmask film formed in Experimental Examples 1 to 12 and Comparative Experimental Examples 1 to 3 were measured. The results thereof are shown in Table 5. An ellipsometer (Horiba) was used.

**[Table 5]**

| | Sample | Refractive index (n@193 nm) | Extinction coefficient (k@193 nm) |
|---|---|---|---|
| Experimental Example 1 | Example 1 | 1.40 | 0.47 |
| Experimental Example 2 | Example 2 | 1.40 | 0.48 |
| Experimental Example 3 | Example 3 | 1.36 | 0.46 |
| Experimental Example 4 | Example 4 | 1.38 | 0.47 |
| Experimental Example 5 | Example 5 | 1.38 | 0.48 |
| Experimental Example 6 | Example 6 | 1.40 | 0.49 |
| Experimental Example 7 | Example 7 | 1.39 | 0.48 |
| Experimental Example 8 | Example 8 | 1.40 | 0.48 |
| Experimental Example 9 | Example 9 | 1.37 | 0.49 |
| Experimental Example 10 | Example 10 | 1.38 | 0.49 |
| Experimental Example 11 | Example 11 | 1.38 | 0.50 |
| Experimental Example 12 | Example 12 | 1.39 | 0.50 |
| Comparative Experimental Example 1 | Comparative Example 1 | 1.44 | 0.68 |
| Comparative Experimental Example 2 | Comparative Example 2 | 1.44 | 0.69 |
| Comparative Experimental Example 3 | Comparative Example 3 | - | - |

The refractive index (n@193 nm) and extinction coefficient (k@193 nm) of the hardmask film were measured as shown in Table 5, except for ruling out Comparative Experimental Example 3 where the evaluation had failed to proceed due to poor coating properties. The refractive index (n@193 nm) of the hardmask film may be evaluated as excellent when being 1.41 or less, and the extinction coefficient (k@193 nm) may be evaluated as excellent when being 0.50 or less.

Experimental Examples 1 to 12 exhibited refractive indices of 1.41 or less and extinction coefficients of 0.50 or less and thus were confirmed to be excellent compared to Comparative Experimental Examples 1 and 2. Among Experimental Examples 1 to 12, Experimental Example 3 exhibited a refractive index of 1.36 and an extinction coefficient of 0.46, thus showing the best results.

### <Evaluation of dry etch characteristics>

The hardmask films formed in Experimental Examples 1 to 12 and Comparative Experimental Examples 1 to 2 were dry-etched using CF₄ gas for 20 seconds on dry etch equipment. Dry etch rates were quantified using Equations 2 and 3 shown below. Dry etch characteristics described the dry etch rate of the hardmask film, assuming that an amorphous carbon layer (ACL) was dry-etched to 100%. When measuring the film thickness, a scanning electron microscope (FE-SEM, Hitachi) was used to examine the cross sections. The measurement results thereof are shown in Table 6, except for ruling out Comparative Experimental Example 3 where the evaluation had failed to proceed due to poor coating properties. Etching result (Å/sec) = (film thickness before dry etching - film thickness after dry etching)/(process time of dry etching) CF4 etch characteristics relative to ACL (%) = {(etching result of sample)/(etching result of ACL)} x 100

**[Table 6]**

| | Sample | CF₄ etch characteristics relative to ACL |
|---|---|---|
| Experimental Example 1 | Example 1 | 90.1% |
| Experimental Example 2 | Example 2 | 91. 6 |
| Experimental Example 3 | Example 3 | 92.5% |
| Experimental Example 4 | Example 4 | 92.4% |
| Experimental Example 5 | Example 5 | 90.4% |
| Experimental Example 6 | Example 6 | 92.1% |
| Experimental Example 7 | Example 7 | 90.2% |
| Experimental Example 8 | Example 8 | 91. 9 |
| Experimental Example 9 | Example 9 | 90.4% |
| Experimental Example 10 | Example 10 | 92.1% |
| Experimental Example 11 | Example 11 | 90.5% |
| Experimental Example 12 | Example 12 | 92.2% |
| Comparative Experimental Example 1 | Comparative Example 1 | 57.4% |
| Comparative Experimental Example 2 | Comparative Example 2 | 79.6% |
| Comparative Experimental Example 3 | Comparative Example 3 | - |
| ACL | | 100% |

When the dry etch rate of the hardmask film is 90% or higher relative to the dry etch rate of the ALC, the etch resistance may be defined as excellent. As a result of comparing Experimental Examples 1 to 12 with Comparative Experimental Examples 1 to 2, Experimental Examples 1 to 12 exhibited CF₄ etch characteristics of 90% or higher and thus confirmed the results of excellent etch resistance. In particular, Experimental Example 3 exhibited the CF₄ etch characteristics relative to the ACL of 92.5%, thus showing the best results.

The foregoing has described in detail certain aspects of the present disclosure. Thus, it will be apparent to those skilled in the art that these specific descriptions are only preferred embodiments, and the scope of the present disclosure is not limited thereby. Accordingly, the substantial scope of the present disclosure will be defined by the appended claims and their equivalents.

## Claims

1. A spin-on hardmask composition with high planarization properties, the hardmask composition comprising:
a 3',6'-dihydroxy-3H-spiro[2-benzofuran-1,9'-xanthen]-3-one derivative polymer represented by Formula 1 shown below;
an organic solvent; and
a surfactant, 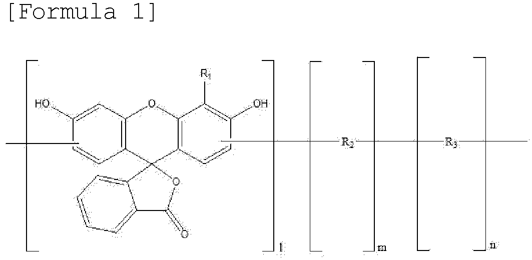
wherein in Formula 1 shown above, l, m, and n are in ranges of 1 ≤ l ≤ 20, 1 ≤ m ≤ 40, and 1 ≤ n ≤ 20, respectively,
R₁ comprises any one among hydrogen (H), a hydroxy group (OH), a ketone group (CO), an ether group (COC), an aldehyde group (CHO), 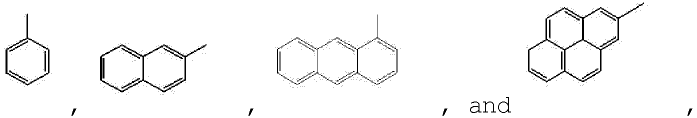
R₂ comprises any one among 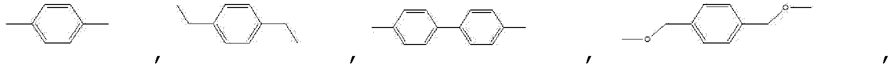 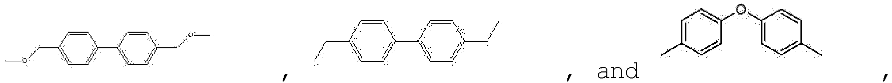 and
R₃ comprises any one among hydrogen (H), a hydroxy group (OH),

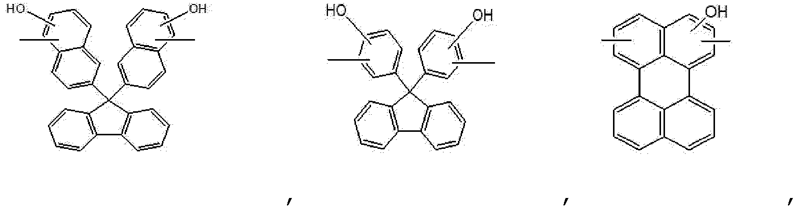

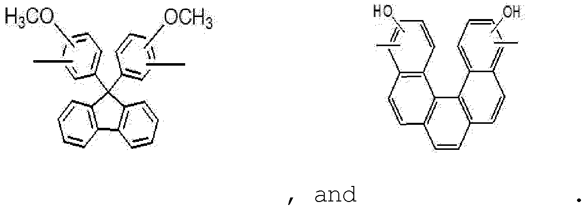

2. The hardmask composition of claim 1, wherein the hardmask composition comprising the polymer having a weight average molecular weight in a range of 1,000 to 5,000 exhibits a planarity of 20% or less at a thickness of 4,000 Å or smaller.

3. The hardmask composition of claim 2, wherein the polymer has a weight average molecular weight in a range of 1,000 to 4,000.

4. The hardmask composition of claim 3, wherein the polymer has a weight average molecular weight in a range of 1,500 to 3,000.

5. The hardmask composition of claim 1, wherein the polymer, the surfactant, and the organic solvent account for 1 to 50 wt%, greater than 0 to 2 wt%, and 50 to 99 wt%, respectively, based on the total weight of the hardmask composition.

6. The hardmask composition of claim 1, wherein the organic solvent is one or a mixture of two or more selected from the group consisting of propyleneglycolmonomethylether (PGME), propyleneglycolmonomethylether acetate (PGMEA), cyclohexanone (CHN), cyclopentanone (CPN), γ-butyrolactone (GBL), ethyllactate (EL), methylethylketone (MEK), n-butylacetate, N-methylpyrrolidone (NMP), methyl 3-methoxypropionate (MMP), and ethyl 3-ethoxypropionate (EEP).

7. The hardmask composition of claim 1, wherein the surfactant is one or a mixture of two or more selected from the group consisting of polyacrylates, polyfluorocarbons, polysiloxanes, polyoxyethylenealkylethers, polyoxyethylenealkylphenylethers, polyoxyethylenenonylphenylethers, polyoxyethyleneoctylphenylethers, polyoxyethylenepolyoxypropylenes, polyoxyethylenelaurylethers, or polyoxyethylenesorbitans.

8. A patterning method comprising:
performing a coating process of an upper portion of a layer to be etched with the hardmask composition of any one of claims 1 to 7 through spin coating; and
performing a baking process to form a hardmask layer.

9. The patterning method of claim 8, wherein the baking process is performed at a temperature in a range of 150°C to 400°C for 1 to 5 minutes to form the hardmask layer.
